# EUROPEAN PATENT APPLICATION

(11) **EP 4 586 300 A1**
(43) Date of publication of application: **16.07.2025**
(21) Application number: 23862105.6
(22) Date of filing: 02.08.2023
(51) Int. Cl.: H01J 37/32, H01L 21/205, C23C 16/455, C23C 16/52

(54) **SPRAY ASSEMBLY, SEMICONDUCTOR DEVICE, AND WAFER PROCESSING METHOD**

(30) Priority: 09.09.2022 CN 202211105794
(71) Applicant: JIANGSU LEADMICRO NANO TECHNOLOGY CO., LTD., Wuxi, Jiangsu 214028 (CN)
(72) Inventor: ZHI, Shunhua, Wuxi, Jiangsu 214028 (CN); XU, Suochang, Wuxi, Jiangsu 214028 (CN)
(74) Representative: Ipsilon Lyon
(86) International application number: PCT/CN2023/110761
(87) International publication number: WO 2024/051405

(57) **Abstract**

The present invention provides a spray assembly, a semiconductor device and a method for processing a wafer. An annular spray plate is provided; a plurality of independent spray areas are formed at an annular area of the spray plate; the flow rate and concentration of introduced reactants can be adjusted respectively according to requirements; these spray areas are distributed annularly and can be arranged at an edge area of a central gas inlet; and the flow rate and concentration of reactants introduced into different spray areas can be adjusted respectively according to requirements, so that the consistency of surface process parameters of the wafer can be adjusted, and the uniformity of the deposition thickness of an edge area and a central area of the wafer can be improved.

## Description

### BACKGROUND OF THE INVENTION

### 1. Technical Field

The present invention relates to the fields of semiconductor devices and manufacturing, and in particular to a spray assembly, a semiconductor device and a method for processing a wafer.

### 2. Description of Related Art

A plasma enhancement technology is widely applied to the field of semiconductor manufacturing, which can improve the activation energy of a reactant in the reaction process, and can significantly reduce the reaction deposition temperature and reduce a stress introduced between a deposition layer and a base layer caused by inconsistent coefficients of thermal expansion.
Remote plasma system (RPS) atomic layer deposition (ALD) is one of ALD devices. Plasma generated after radio frequency treatment of a reaction gas is provided into a chamber from an inlet. This method has less bombardment on the surface of a wafer and generates less plasma damage. However, the remote plasma is relatively far away from the wafer and the diffusion path is long, so that ion beams in an excited state and on the surface of the wafer are distributed non-uniformly. Generally, the central area of the wafer has high density and the edge area has low density, resulting in the non-uniform deposition thickness of the central and edge areas of the wafer.

### BRIEF SUMMARY OF THE INVENTION

In view of this, an objective of the present invention is to provide a spray assembly, a semiconductor device and a method for processing a wafer, thereby improving the deposition thickness uniformity of an edge area and a central area of the wafer.

To achieve the above objective, the present invention has the following technical solution:
a spray assembly, applied to a semiconductor device and configured to be arranged at an edge area of a central gas inlet of the semiconductor device, includes a first spray plate and a second spray plate which are stacked, where the first spray plate and the second spray plate are annular plates arranged coaxially;
the first spray plate is provided with a first annular spray area and a spray import area which are arranged coaxially with the first spray plate; and
the second spray plate is provided with a second annular spray area arranged coaxially with the second spray plate, the second annular spray area is arranged corresponding to the spray import area, the spray import area is configured to import a reactant in the second annular spray area into a chamber, and the first annular spray area and the second annular spray area are independent of each other.

Optionally, the first annular spray area is configured to an inner ring spray area, and the second annular spray area is configured to cooperate with the spray import area to form an outer ring spray area.

Optionally, the second annular spray area is configured to cooperate with the spray import area to form an inner ring spray area, and the first annular spray area is configured to cooperate with the spray import area to form an outer ring spray area.

Optionally, the first spray area is further provided with a first gas inlet hole communicating with the first annular spray area, and the second spray plate is further provided with a second gas inlet hole communicating with the second annular spray area.

Optionally, the first annular spray area includes a first annular groove and a first spray hole penetrating through the first annular groove, the second annular spray area includes a second annular groove and a second spray hole penetrating through the second annular groove, the spray import area includes an annular through hole area arranged on the first spray plate, the annular through hole area is provided with a penetrating hole, and the second spray hole at least partially penetrates through the penetrating hole.

Optionally, the first spray hole and the second spray hole are distributed respectively uniformly, with a hole diameter range of 0.2-3 mm.

Optionally, the second spray plate is arranged below a chamber cover plate of the semiconductor device, and the first spray plate is arranged below the second spray plate.

A spray assembly includes an annular plate, where a first spray area and a second spray area which are arranged coaxially are arranged on the annular plate at intervals, the first spray area includes an inner groove ring and a first spray hole formed in the inner groove ring, and the second spray area includes an outer groove ring and a second spray hole formed in the outer groove ring.

Optionally, the spray assembly further includes a gas inlet cover plate, where the gas inlet cover plate is located above the annular plate, a first gas inlet channel and a second gas inlet channel are respectively formed in the gas inlet cover plate, the first gas inlet channel penetrates through the inner groove ring, and the second gas inlet channel penetrates through the outer groove ring.

Optionally, the spray assembly further includes a gas inlet cover plate, where the gas inlet cover plate is located above the annular plate, a first gas inlet channel is formed in the gas inlet cover plate, and the first gas inlet channel communicates with the inner groove ring; and a second gas inlet channel is further formed in the annular plate, and the second gas inlet channel communicates with the outer groove ring.

Optionally, the gas inlet cover plate is a chamber cover plate.

The semiconductor device is a remote plasma ALD device and includes a tubular radio frequency generator and a reaction chamber, where a central gas inlet is formed at an upper end of the reaction chamber, the central gas inlet is formed corresponding to an outlet of the tubular radio frequency generator, and the spray assembly according to any one of the above is arranged in the reaction chamber and below the tubular radio frequency generator.

Optionally, the tubular radio frequency generator includes a gas pipeline and a plurality of coil pipelines arranged at the periphery of the gas pipeline, each of the coil pipelines includes coils arranged spirally, and the plurality of coil pipelines have different diameters.

A method for processing a wafer includes:
placing the wafer in the reaction chamber of the semiconductor device according to any one of the above; and
performing process treatment on the wafer.
According to the spray assembly, the semiconductor device and the method for processing the wafer provided by the embodiments of the present invention, an annular spray plate is provided; a plurality of independent spray areas are formed at an annular area of the spray plate; the flow rate and concentration of introduced reactants can be adjusted respectively according to requirements; these spray areas are distributed annularly and are arranged at an edge area of a central gas inlet of the semiconductor device; and the flow rate and concentration of reactants introduced into different spray areas can be adjusted respectively according to requirements, and the gas flow density of the edge area is supplemented and adjusted, so that the consistency of surface process parameters of the wafer can be adjusted, and the uniformity of the deposition thickness of an edge area and a central area of the wafer can be improved.

### BRIEF DESCRIPTION OF THE SEVERAL VIEWS OF THE DRAWINGS

To describe the technical solutions in the embodiments of the present invention or in the prior art more clearly, the following briefly describes the accompanying drawings required for describing the embodiments or the prior art. Apparently, the accompanying drawings in the following description show some embodiments of the present invention, and those of ordinary skill in the art may still derive other drawings from these accompanying drawings without creative efforts.
FIG. 1A is a schematic diagram of a three-dimensional structure of a spray assembly according to Embodiment 1 of the present invention;
FIG. 1B is a schematic diagram of a sectional structure of a semiconductor device according to Embodiment 1 of the present invention;
FIG. 2A is a schematic diagram of a three-dimensional structure of a spray assembly according to Embodiment 2 of the present invention;
FIG. 2B is a schematic diagram of a sectional structure of a semiconductor device according to Embodiment 2 of the present invention;
FIG. 3A is a schematic diagram of a three-dimensional structure of a spray assembly according to Embodiment 3 of the present invention;
FIG. 3B is a schematic diagram of a three-dimensional structure of a chamber cover plate cooperating with Embodiment 3 of the present invention;
FIG. 3C is a sectional schematic diagram of FIG. 3B; and
   FIG. 3D is a schematic diagram of a sectional structure of a semiconductor device according to Embodiment 3 of the present invention.

### DETAILED DESCRIPTION OF THE INVENTION

To make the foregoing objectives, features and advantages of the present invention more apparent and comprehensible, the specific embodiments of the present invention are described in detail below with reference to the accompanying drawings.

A number of specific details are set forth in the description below to provide a thorough understanding for the present invention; however, the present invention may also be implemented in other manners different from those described herein, and those skilled in the art may make similar generalization without departing from the essence of the present invention; and therefore, the present invention is not limited by the specific embodiments disclosed below.

As described in the background, a remote plasma ALD device introduces a reactant gas from a central gas inlet, a remote plasma is relatively far away from a wafer, and the diffusion path is long, so that ion beams in an excited state and on the surface of the wafer are distributed non-uniformly, resulting in the non-uniform deposition thickness of central and edge areas of the wafer. Therefore, this patent provides a spray assembly. The spray assembly is an annular spray plate and can be arranged around a central gas inlet hole of the remote plasma ALD device. A plurality of annular independent spray areas are formed, the flow rate and concentration of reactants introduced into different spray areas can be adjusted respectively according to requirements, and the gas flow density of the edge area can be supplemented and adjusted, so that the process consistency of the edge area and the central area can be improved. To better understand the present invention, the following description will be combined with different embodiments, and the following description will take assembly structures of two annular independent spray areas as an example.

In some embodiments, the two independent spray areas can be formed on two spray plates, a spray area and a spray import area are formed on one spray plate, another spray area is formed on the other spray plate, the spray area is arranged at a position corresponding to the spray import area, and a reactant enters the spray area and then enters a chamber through the spray import area. In these embodiments, the independent spray areas are implemented more flexibly.

### Embodiment 1 and Embodiment 2

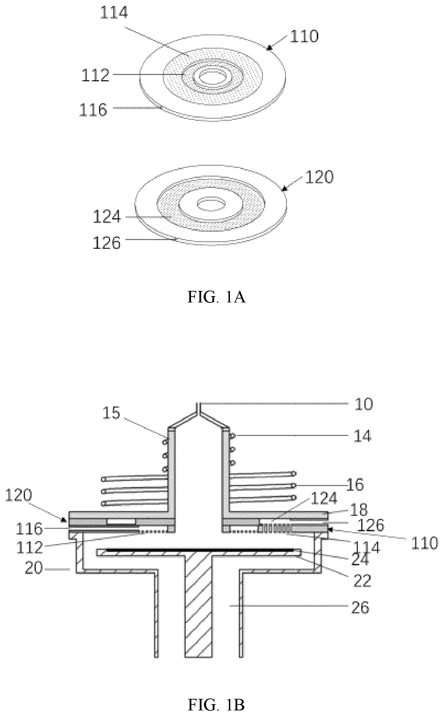

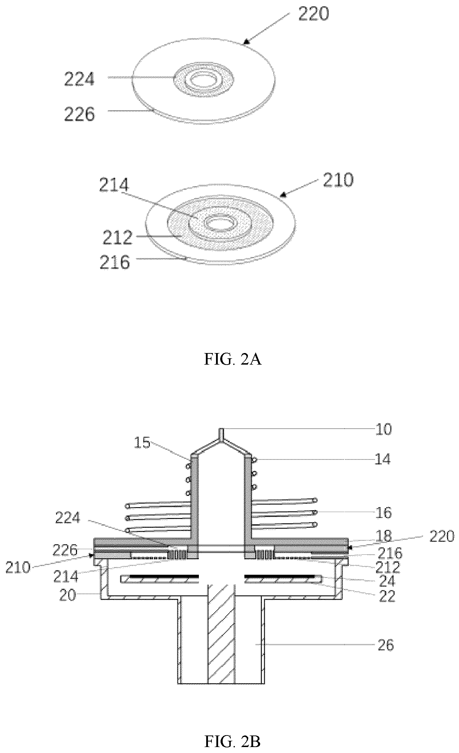

Referring to FIG. 1A, FIG. 1B, FIG. 2A and FIG. 2B, the spray assembly includes a first spray plate 110 and a second spray plate 120 which are stacked, and the two spray plates are arranged coaxially.

A first annular spray area 112 and a spray import area 114 are respectively arranged on the first spray plate 110, a second annular spray area 124 is arranged on the second spray plate 120 and at a position corresponding to the spray import area 114, and the spray import area 114 corresponds to the second spray area 124 in position and is configured to further import a reactant in the second spray area 124 into a chamber.

In the embodiments of the present invention, the annular spray areas 112 and 124 can import the reactant and have an accommodating space for the reactant and a gas outlet spray hole of the reactant, the accommodating space can be formed together with the adjacent parts during use, and the spray import area 114 is configured to further import the reactant in the spray area 124 into the chamber. The first annular spray area 112 and the second annular spray area 124 are spray areas independent of each other, the accommodating spaces of the reactants in the spray areas are independent of each other, and the import paths of the reactants are also independent.

In some applications, the first annular spray area 112 may include a first groove formed in the first spray plate 110 and a first spray hole formed in the first groove, the second annular spray area 124 may include a second groove formed in the second spray plate 120 and a second spray hole formed in the second groove, the spray import area 114 may include an annular through hole area arranged on the first spray plate, that is, an annular area formed by a penetrating hole communicates with at least part of a second through hole in the second annular spray area 124 through the penetrating hole of the annular through hole area, so that the reactant in the second spray area 124 penetrates into the chamber.

The first spray hole, the second spray hole and the penetrating hole are through holes distributed regularly. In a specific embodiment, these through holes may be arranged in the same or different manners. The hole diameters of the through holes may be the same or different, preferably, the hole diameters of the through holes may be selected within the range of 0.2-3 mm.

As shown in FIG. 1A and FIG. 1B, in Embodiment 1, the first spray plate 110 is located below the second spray plate 120, the first annular spray area 112 is configured to form an inner ring spray area, and the second annular spray area 124 is configured to form an outer ring spray area. The first spray plate 110 is further provided with a first gas inlet hole 116 penetrating through the inner ring spray area 112, and the reactant is imported into the inner ring spray area through the gas inlet hole 116 formed in the first spray plate 110. The second spray plate 120 is provided with a second gas inlet hole 126 penetrating through the outer ring spray area 124, and the reactant is imported to the outer ring spray area through the gas inlet hole 126 formed in the second spray plate 120. In this embodiment, the reactant is imported to the spray area through the gas inlet hole formed in the spray plate, and the structure is simple and easy to integrate. In other embodiments, the structure may be implemented in other manners, for example, a cover plate with a ventilation pipeline may be provided additionally, the cover plate is arranged above the spray plate, and the reactant is imported from a part above the spray area through the ventilation pipeline in the cover plate.

As shown in FIG. 2A and FIG. 2B, in Embodiment 2, the first spray plate 210 is located below the second spray plate 220, the first annular spray area 212 is configured to form an outer ring spray area, and the second annular spray area 224 is configured to form an inner ring spray area. The first spray plate 210 is further provided with a first gas inlet hole 216 penetrating through the outer ring spray area 212, and the reactant is imported to the outer ring spray area through the gas inlet hole 216 in the first spray plate 210. The second spray plate 220 is provided with a second gas inlet hole 226 penetrating through the inner ring spray area 224, and the reactant is imported to the inner ring spray area through the gas inlet hole 226 in the second spray plate 220. The same as Embodiment 1, in this embodiment, the reactant is imported to the spray area through the gas inlet hole formed in the spray plate, and the structure is simple and easy to integrate. In other embodiments, the structure may be implemented in other manners, for example, a cover plate with a ventilation pipeline may be provided additionally, the cover plate is arranged above the spray plate, and the reactant is imported from a part above the spray area through the ventilation pipeline in the cover plate.

In the specific application of the above embodiments, the second spray plate 120 may be located below a chamber cover plate 18, the second annular spray area 124 cooperates with the adjacent chamber cover plate 18 to form an accommodating space for the reactant, the first spray plate 110 is located below the second spray plate 120, and the first annular spray area 112 cooperates with the adjacent second spray plate 120 to form an accommodating space for the reactant.

It should be noted that to facilitate the understanding of the specific structure of the embodiments of the present invention, in the sectional views provided in FIG. 1B and FIG. 2B, the specific structure is shown along the position where the section can display the first gas inlet hole and the second gas inlet hole conveniently and does not represent the relative position relationship between the two, and in the actual application, the first gas inlet hole and the second gas inlet hole may be respectively formed at the appropriate positions of the first spray plate and the second spray plate.

### Embodiment 3

In some other embodiments, different annular spray areas may be arranged on one spray plate, and the structure is simpler.

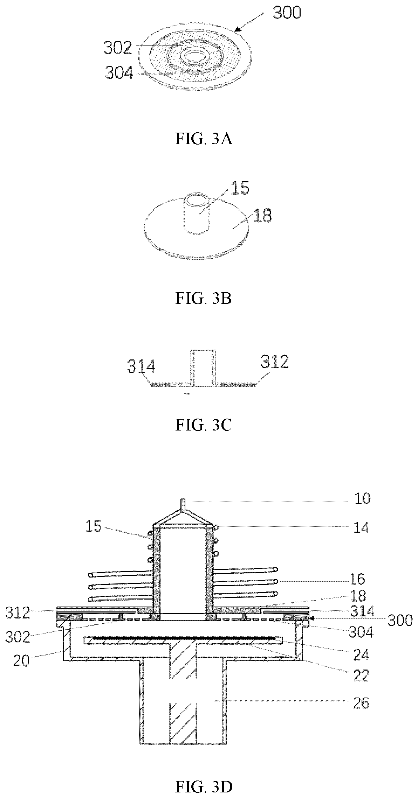

Referring to FIG. 3A to FIG. 3D, in these embodiments, the spray assembly includes an annular plate 300, where a first spray area 302 and a second spray area 304 which are arranged coaxially are arranged on the annular plate 300 at intervals, the first spray area 302 includes an inner groove ring and a first spray hole formed in the inner groove ring, and the second spray area 304 includes an outer groove ring and a second spray hole formed in the outer groove ring.

The reactants are respectively imported to the first spray area 302 and the second spray area 304 through independent gas inlet paths, part of all of the gas inlet channels may be provided through another gas inlet cover plate, and a gas inlet pipeline in the gas inlet cover plate provides the reactant to the spray area from the part above the spray area.

In some specific embodiments, as shown in FIG. 3A and FIG. 3D, the spray assembly further includes a gas inlet cover plate 18, where the gas inlet cover plate 18 is located above the annular plate 300, a first gas inlet channel 312 and a second gas inlet channel 314 are respectively formed in the gas inlet cover plate 18, the first gas inlet channel 312 penetrates through the inner groove ring, and the second gas inlet channel 314 penetrates through the outer groove ring.

In some other specific embodiments (not shown in the figure), the spray assembly further includes a gas inlet cover plate, where the gas inlet cover plate is located above the annular plate, a first gas inlet channel is formed in the gas inlet cover plate, and the first gas inlet channel communicates with the inner groove ring; and a second gas inlet channel is further formed in the annular plate, and the second gas inlet channel communicates with the outer groove ring.

The gas inlet cover plate 18 may be of an independent cover plate structure, or may be integrated with other structures. In the preferable embodiment, the gas inlet cover plate 18 may be a chamber cover plate.

The above describes the spray assembly according to the embodiments of the present invention in detail. In addition, the present invention further provides the remote plasma ALD device, referring to FIG. 1B, FIG.2B and FIG. 3D, including a tubular radio frequency generator and a reaction chamber 20, where a central gas inlet is formed at an upper end of the reaction chamber 20, the central gas inlet is formed corresponding to an outlet of the tubular radio frequency generator, the spray assembly with any one of the above structures is arranged in the reaction chamber 20 and below the tubular radio frequency generator, and the annular spray area of the spray assembly is located at the periphery of a gas outlet of the tubular radio frequency generator.

The tubular radio frequency generator converts the input process gas into a plasma reactant, a supporting base 22 is arranged in the chamber, the supporting base 22 is configured to place a wafer to be processed, and a gas outlet of the tubular radio frequency generator is located above a central area of a wafer 24. The remote plasma is relatively far away from the wafer and the diffusion path is long, so that ion beams in an excited state and on the surface of the wafer are distributed non-uniformly. The density of the central area of the wafer is higher than that of the edge area. The spray assembly is provided, the spray assembly is provided with an independent edge spray area located around a main gas inlet, and the flow rate and concentration of the introduced reactant can be adjusted respectively according to requirements, so that the consistency of surface process parameters of the wafer can be adjusted, and the deposition thickness uniformity of the edge area and the central area of the wafer can be improved.

In the embodiments of the present invention, the tubular radio frequency generator includes a gas pipeline 15 and a plurality of coil pipelines 14 and 16, each of the coil pipelines includes coils distributed spirally, one or more coils may be provided, and the plurality of coil pipelines 14 and 16 have different diameters. Different powers are set for different coils, so that after the process gas enters from the gas inlet, the coil pipeline with the small diameter implements plasma ignition first and is diffused downward along with the flow of the gas, and the coil pipeline with the large diameter starts to excite plasma, thereby further improving the distribution uniformity of edge plasma.

In addition, the present invention further provides a method for processing a wafer. After the wafer is placed on the remote plasma ALD device, the wafer is subjected to process treatment.

The above is only the preferable embodiment of the present invention. The preferred embodiments have been disclosed in the present invention, but are not intended to limit the present invention. Any person skilled in the art can make many possible variations and modifications to the technical solutions of the present invention, or modify them to be equivalent embodiments of the variations, without departing from the spirit and technical solutions of the present invention. Therefore, any simple modification, equivalent change and modification made to the above embodiments according to the technical essence of the present invention without departing from the content of the technical solution of the present invention still fall within the scope of protection of the technical solution of the present invention.

## Claims

1. A spray assembly, applied to a semiconductor device, configured to be arranged at an edge area of a central gas inlet of the semiconductor device, and comprising a first spray plate and a second spray plate which are stacked, **characterized in that** the first spray plate and the second spray plate are annular plates arranged coaxially;
the first spray plate is provided with a first annular spray area and a spray import area which are arranged coaxially with the first spray plate; and
the second spray plate is provided with a second annular spray area arranged coaxially with the second spray plate, the second annular spray area is arranged corresponding to the spray import area, the spray import area is configured to import a reactant in the second annular spray area into a chamber, and the first annular spray area and the second annular spray area are independent of each other.

2. The spray assembly according to claim 1, **characterized in that** the first annular spray area is configured to an inner ring spray area, and the second annular spray area is configured to cooperate with the spray import area to form an outer ring spray area.

3. The spray assembly according to claim 1, **characterized in that** the second annular spray area is configured to cooperate with the spray import area to form an inner ring spray area, and the first annular spray area is configured to cooperate with the spray import area to form an outer ring spray area.

4. The spray assembly according to claim 1, **characterized in that** the first spray area is further provided with a first gas inlet hole communicating with the first annular spray area, and the second spray plate is further provided with a second gas inlet hole communicating with the second annular spray area.

5. The spray assembly according to any one of claims 1 to 4, **characterized in that** the first annular spray area comprises a first annular groove and a first spray hole penetrating through the first annular groove, the second annular spray area comprises a second annular groove and a second spray hole penetrating through the second annular groove, the spray import area comprises an annular through hole area arranged on the first spray plate, the annular through hole area is provided with a penetrating hole, and the second spray hole at least partially penetrates through the penetrating hole.

6. The spray assembly according to 5, **characterized in that** the first spray hole and the second spray hole are distributed respectively uniformly, with a hole diameter range of 0.2-3 mm.

7. The spray assembly according to 5, **characterized in that** the second spray plate is arranged below a chamber cover plate of the semiconductor device, and the first spray plate is arranged below the second spray plate.

8. A spray assembly, comprising an annular plate, **characterized in that** a first spray area and a second spray area which are arranged coaxially are arranged on the annular plate at intervals, the first spray area comprises an inner groove ring and a first spray hole formed in the inner groove ring, and the second spray area comprises an outer groove ring and a second spray hole formed in the outer groove ring.

9. The spray assembly according to claim 8, further comprising a gas inlet cover plate, **characterized in that** the gas inlet cover plate is located above the annular plate, a first gas inlet channel and a second gas inlet channel are respectively formed in the gas inlet cover plate, the first gas inlet channel penetrates through the inner groove ring, and the second gas inlet channel penetrates through the outer groove ring.

10. The spray assembly according to claim 8, further comprising a gas inlet cover plate, **characterized in that** the gas inlet cover plate is located above the annular plate, a first gas inlet channel is formed in the gas inlet cover plate, and the first gas inlet channel communicates with the inner groove ring; and a second gas inlet channel is further formed in the annular plate, and the second gas inlet channel communicates with the outer groove ring.

11. The spray assembly according to claim 9 or 10, **characterized in that** the gas inlet cover plate is a chamber cover plate.

12. A semiconductor device, being a remote plasma ALD device and comprising a tubular radio frequency generator and a reaction chamber, **characterized in that** a central gas inlet is formed at an upper end of the reaction chamber, the central gas inlet is formed corresponding to an outlet of the tubular radio frequency generator, and the spray assembly according to any one of claims 1 to 11 is arranged in the reaction chamber and below the tubular radio frequency generator.

13. The semiconductor device according to claim 12, **characterized in that** the tubular radio frequency generator comprises a gas pipeline and a plurality of coil pipelines arranged at the periphery of the gas pipeline, each of the coil pipelines comprises coils arranged spirally, and the plurality of coil pipelines have different diameters.

14. A method for processing a wafer, comprising:
placing the wafer in the reaction chamber of the semiconductor device according to claim 12 or 13; and
performing process treatment on the wafer.
